# FASCICULE DE BREVET EUROPEEN

(11) **EP 2 019 301 B1**
(45) Date de publication et mention de la délivrance du brevet: **01.05.2013**
(21) Numéro de dépôt: 08305392.6
(22) Date de dépôt: 10.07.2008
(51) Int. Cl.: G01J 5/20, B81B 3/00, H01L 27/146

(54) **Détecteur de rayonnement électromagnétique et procédé de fabrication d'un tel détecteur**
Elektromagnetische Strahlensonde und Herstellungsverfahren einer solchen Sonde
Electromagnetic radiation detector and method of manufacturing such a detector

(30) Priorité: 20.07.2007 FR 0705271
(43) Date de publication de la demande: 28.01.2009
(73) Titulaire: ULIS, 38113 Veurey Voroize (FR)
(72) Inventeur: VILAIN, Michel, 38450, SAINT GEORGES DES COMMIERS (FR)
(74) Mandataire: Vuillermoz, Bruno

(56) Documents cités:
- WO-A-00/37906
- US-A- 5 912 464
- US-B1- 6 198 098

## Description

### DOMAINE DE L'INVENTION

La présente invention a trait au domaine de l'imagerie. Elle concerne notamment le domaine de l'imagerie infrarouge et de la pyrométrie bolométrique.

Plus particulièrement, la présente invention concerne un détecteur comportant un substrat réfléchissant et au moins un élément de détection comprenant une membrane sensible à un rayonnement électromagnétique, suspendue au-dessus du substrat.

### ETAT ANTERIEUR DE LA TECHNIQUE

Les détecteurs bolométriques appartiennent à une catégorie de détecteurs comprenant un arrangement matriciel d'éléments sensibles unitaires à membrane suspendue. Chacun de ces éléments unitaires comprend une membrane, rendue absorbante vis-à-vis d'un rayonnement électromagnétique dans une gamme prédéterminée de longueurs d'onde et maintenue en suspension au-dessus d'un substrat réfléchissant à l'aide de structures thermiques résistives, qui permettent son échauffement sous l'effet du rayonnement ainsi que sa connexion électrique au substrat. Les documents US 5 912 464 et WO 00/37906 divulguent des détecteurs bolométriques.

Par substrat, on entend ici le composant physique localisé directement au-dessous de la membrane. Usuellement, le substrat comprend un substrat dit de « construction », dans lequel est réalisé un circuit électronique de lecture, d'une couche de passivation recouvrant le substrat de construction et d'une couche réfléchissante recouvrant la couche de passivation.

Dans le cas d'un détecteur bolométrique, la membrane comprend un matériau bolométrique, c'est-à-dire un matériau dont la résistivité varie avec la température de celui-ci. La variation de résistivité du matériau bolométrique sous l'effet d'une variation de température est alors détectée par le circuit électronique de lecture réalisé sur le substrat.

La membrane et le substrat sont généralement conçus essentiellement sous forme plane, et sont disposés parallèlement l'un à l'autre à une distance prédéterminée de manière à former entre eux une lame quart d'onde. Cette lame quart d'onde a pour effet d'optimiser par un phénomène de résonance la réponse du détecteur dans la gamme de longueurs d'onde d'intérêt.

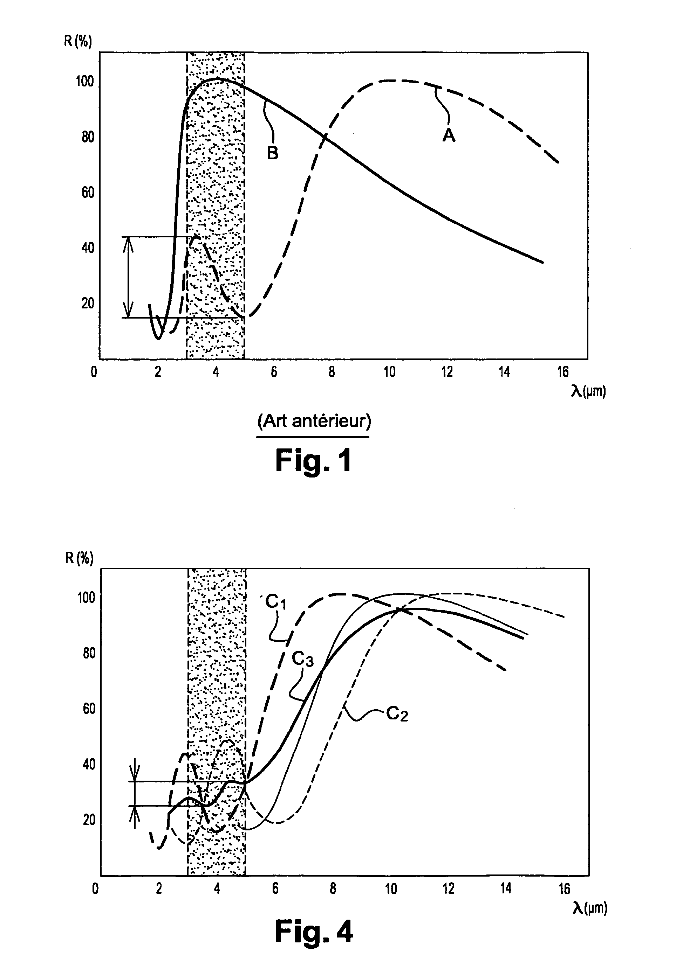

Ainsi, dans le cas d'un détecteur bolométrique destiné à l'observation d'un rayonnement infrarouge thermique à température ambiante, c'est-à-dire un rayonnement de longueur d'onde comprise entre 8 et 14 micromètres, la distance entre la membrane et le substrat est ajusté à environ 2,5 micromètres. On observe alors une réponse du détecteur bolométrique à la longueur d'onde du rayonnement telle qu'illustrée par la courbe A de la figure 1.

Il est important de remarquer que dans ce type de détecteur à membrane suspendue au-dessus d'un substrat réfléchissant de manière à former une cavité résonnante, la réponse présente également des pics secondaires correspondant à des ordres d'interférence supérieurs. Typiquement, dans le cas du détecteur bolométrique précité, on observe un pic secondaire étroit, mais d'amplitude élevée, aux environs de 2,5 micromètres, comme cela est visible sur la courbe A précitée de la figure 1.

Toutefois, dans ce type de détecteur, la gamme de longueurs d'onde détectée est restreinte, en raison du fait que le ou les pics secondaires sont étroits et la réponse du détecteur entre les pics trop faible pour une exploitation correcte.

Une première approche pour augmenter la gamme de détection de ce type de capteur consiste à utiliser deux types de structures de détection juxtaposées ou superposées, chacune de ces structures étant sensible à une gamme de longueurs d'onde donnée. Ce type de détecteurs est complexe à fabriquer, surtout dans le cas des structures superposées. De plus, de tels détecteurs présentent nécessairement une résolution réduite car il faut prévoir deux fois plus d'éléments sensibles par unité de surface.

Une seconde approche pour augmenter la gamme de détection consiste à utiliser la présence des pics secondaires dans la réponse du capteur. Cette approche est cependant délicate à mettre en oeuvre, en particulier en considérant le cas où l'utilisateur se concentre par exemple sur une longueur d'onde précise (cas de la détection de polluants atmosphériques typiquement), cette longueur d'onde pouvant se situer sur les flancs d'un pic de sensibilité, auquel cas de faibles distorsions du spectre de sensibilité d'un point sensible à l'autre dans un même détecteur matriciel, et entre détecteurs différents (problème du constructeur de détecteurs), conduisent à de grandes variations de signal à cette longueur d'onde.

Ainsi, lorsque la longueur d'onde d'intérêt tombe sur le flanc d'un pic, la dispersion est ordinairement très élevée. Le détecteur est donc de ce point de vue peu précis.

Ainsi, la détection sur une gamme étendue de longueurs d'onde en deçà du pic principal est peu reproductible du fait de la dispersion d'un détecteur à l'autre et de la dispersion à l'intérieur d'un même détecteur.

Par ailleurs, toujours dans le cas où l'utilisateur se concentre sur une gamme très étroite de longueurs d'onde, la réponse du détecteur hors le pic principal et le pic secondaire est généralement faible. L'exploitation du détecteur dans des gammes de longueurs d'onde éloignées des pics est alors difficile, voire impossible.

En outre, l'utilisation d'un pic secondaire consiste dans bien des cas à obtenir une détection bispectrale. En effet, en envisageant le cas où l'on veut disposer d'une sensibilité globale élevée entre 3 et 5 micromètres, tout en restant sensible entre 8 et 14 micromètres, pour ainsi constituer un détection bispectrale, la difficulté est maintenant que la variabilité intrinsèque du spectre de la réponse du détecteur dans la gamme de 3 à 5 micromètres résulte là aussi en une dispersion importante du détecteur dans cette gamme, selon les caractéristiques spectrales de la scène observée. Il existe ainsi un effet de filtre qui favorise les longueurs d'onde émises par la scène sur les pics, et atténue les longueurs d'onde émises par la scène dans les vallées inter-pics. La réponse du détecteur est donc relativement peu représentative des caractéristiques thermiques de la scène. Cette réponse est par ailleurs dispersée entre des détecteurs et sur la surface du même détecteur.

Dans le cas plus spécifique d'un détecteur bolométrique dans lequel une résonance est obtenue par une lame quart d'onde, il a également été tenté, selon une troisième approche, d'obtenir une détection optimale dans les infrarouges moyens, c'est-à-dire dans les infrarouges de longueurs d'onde comprises entre 3 et 5 micromètres à l'aide du pic principal de résonance. Cette approche consiste à former une lame quart d'onde dédiée à un tel rayonnement entre la membrane de chaque élément sensible et le substrat, afin d'obtenir une réponse du détecteur conforme à la courbe B de la figure 1.

Cela suppose alors la mise en oeuvre d'une lame quart d'onde submicrométrique et donc de disposer d'une distance maximale séparant la membrane suspendue de l'élément sensible et le substrat, inférieure au micromètre. Or, l'obtention d'une telle distance est difficile car cela nécessite un ajustement d'une précision inférieure au dixième de micromètre. En effet, une erreur de 0,1 micromètre dans la distance entre la membrane et le substrat entraîne une variation de l'ordre de 15 pourcents dans la réponse, rendant de ce fait l'exploitation du détecteur difficile.

Par ailleurs, cette disposition implique un affaiblissement conséquent de la sensibilité du détecteur dans les grandes longueurs d'onde.

Le but de la présente invention est de résoudre les problèmes susmentionnés en proposant un détecteur du type précité présentant une large gamme de détection exploitable, et qui s'avère en outre de fabrication simple.

### EXPOSE DE L'INVENTION

A cet effet, l'invention a pour objet un détecteur comportant un substrat réfléchissant et au moins un élément de détection comprenant une membrane sensible à un rayonnement suspendue au-dessus du substrat, selon la revendication 1.

Selon l'invention, la distance séparant la membrane du au moins un élément de détection et le substrat est variable, ladite distance présentant une distribution spatiale prédéterminée apte à minimiser des variations rapides d'une réponse du détecteur au rayonnement dans au moins une gamme prédéterminée de longueurs d'onde

La variation de la distance entre la membrane et le substrat permet ainsi de moduler la forme d'un pic secondaire de la courbe représentative de la réponse du détecteur en fonction de la longueur d'onde du rayonnement détecté, et notamment son gradient et son amplitude, sans qu'il soit nécessaire pour cela de prévoir une cavité de résonance spécifiquement dédiée à la gamme de longueurs d'onde correspondant à ce pic.

Afin de réaliser une telle variabilité de la distance en question, le substrat et/ou la membrane suspendue présentent des motifs tridimensionnels.

En outre, la membrane et le substrat peuvent être sensiblement parallèles par morceaux.

Selon une forme particulière de réalisation de l'invention, la distance entre la membrane suspendue et le substrat est distribuée entre au moins une première et une seconde valeurs prédéterminées.

En outre, les aires de surfaces correspondant à différentes valeurs de distance entre la membrane et le substrat peuvent être identiques ou différentes.

Selon une application particulière du détecteur de l'invention, la membrane suspendue comporte un matériau bolométrique sensible à une variation de température résultant d'une exposition à un rayonnement infrarouge, la membrane qui le constitue pouvant être sensible à des longueurs d'onde comprises entre environ 3 micromètres et environ 14 micromètres.

Dans cette hypothèse, les première et seconde valeurs de distance séparant la membrane suspendue du substrat sont sensiblement égale à 3 et 2 micromètres respectivement. Selon cette application particulière, le rapport entre la surface de la membrane séparée du substrat par la première distance et la surface de la membrane séparée du substrat par la seconde distance est compris entre environ 35 et environ 50 pourcents.

Selon une caractéristique de l'invention, les motifs tridimensionnels réalisés sur la membrane et/ou sur le substrat sont répétitifs, leur pas de répétition étant inférieur ou égal à 4 micromètres dans le cas particulier de la configuration précédente.

La présente invention a également pour objet un procédé de fabrication d'un détecteur, du type comportant une étape de formation d'un substrat réfléchissant et d'une membrane constitutive d'au moins un élément de détection sensible à un rayonnement, et une étape de suspension de la membrane au-dessus du substrat, selon la revendication 8.

Selon l'invention, l'étape de formation du substrat et de la membrane comporte une étape de création de motifs tridimensionnels dans le substrat et/ou la membrane, de manière à présenter une distribution spatiale prédéterminée apte à minimiser des variations rapides d'une réponse du détecteur au rayonnement dans au moins une gamme prédéterminée de longueurs d'onde.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
- la figure 1 est un graphique de courbes de réponses normalisées de détecteurs de l'état antérieur de la technique ;
- la figure 2 est une vue schématique de dessus d'un premier mode de réalisation d'un détecteur bolométrique selon l'invention ;
- la figure 3 est une vue en section du détecteur de la figure 2 selon le plan III-III de cette figure ;
- la figure 4 est un graphique de courbes de réponses normalisées d'un détecteur bolométrique selon le premier mode de réalisation de l'invention ;
- la figure 5 est une vue schématique de dessus d'un second mode de réalisation d'un détecteur bolométrique selon l'invention ;
- la figure 6 est une vue en section du détecteur de la figure 5 selon le plan VI-VI de cette figure ;
- la figure 7 est une vue schématique de dessus d'un troisième mode de réalisation d'un détecteur bolométrique selon l'invention ; et
- la figure 8 est une vue en section du détecteur de la figure 7 selon le plan VIII-VIII de cette figure.

### MODE DE REALISATION DE L'INVENTION

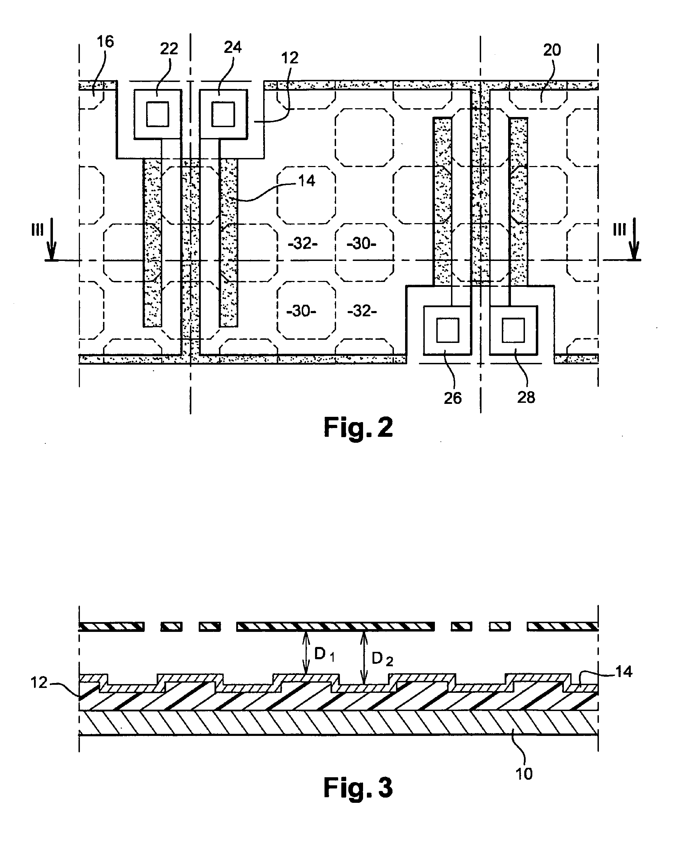

On a représenté au sein des figures 2 et 3, un détecteur bolométrique selon l'invention, dédié à la détection des infrarouges thermiques et moyens. Ce détecteur comporte un substrat de construction **10,** sensiblement plan, dans lequel est réalisé un circuit électronique de lecture (non représenté), bien connu en soi.

Ce détecteur comporte également une couche de passivation **12** recouvrant le substrat de construction **10,** d'une épaisseur de 1 à quelques micromètres, et réalisée en un matériau diélectrique. La couche de passivation **12** est optionnellement recouverte d'une couche additionnelle (non représentée) en matériau diélectrique, tel qu'un oxyde de silicium, un nitrure de silicium ou un matériau mixte, par exemple de l'oxynitrure de silicium.

La passivation des circuits électroniques est formée traditionnellement, pour des raisons diverses, de plusieurs couches qu'il convient en général de ne pas modifier au cours d'un processus ultérieur de formation de cavités, sinon il existe un risque de modifier leur caractère passivant, au moins localement. De manière avantageuse, l'ajout de la couche additionnelle, de nature compatible avec les couches de passivation sous-jacentes, permet d'y former par gravure une texturation, sans modifier pour cela les caractéristiques du circuit de lecture.

Une couche réfléchissante métallique **14,** d'épaisseur comprise entre 0,3 et 1 micromètre, est également prévue et recouvre la couche de passivation **12.**

Enfin, le détecteur comporte une pluralité de membranes bolométriques élémentaires identiques **16, 18, 20,** agencées régulièrement sous forme matricielle, par exemple avec un pas de répétition compris entre 25 et 40 micromètres. Ces membranes **16, 18, 20** sont sensiblement planes et sont suspendues au-dessus de la couche réfléchissante **14** au moyen de bras de suspension **22-26.**

Chaque membrane **16, 18, 20** présente une épaisseur faible, de quelques dixièmes de micromètre, et comporte un matériau bolométrique, tel que par exemple du silicium amorphe (a-Si), de l'oxyde de vanadium (VOx) ou de l'oxyde métallique (Ti).

La membrane **16, 18, 20** présente de plus un pouvoir élevé d'absorption aux longueurs d'onde comprises entre environ 3 micromètres et environ 14 micromètres.

En outre, le pouvoir d'absorption de la membrane **16, 18, 20** est, dans cette gamme, sensiblement indépendant au premier ordre de la longueur d'onde du rayonnement incident. A cet effet, la membrane comporte une couche métallique (non représentée), dont la résistance de couche est comprise entre environ 300 Ohm par carré et environ 400 Ohm par carré. La membrane est par exemple du type de celle décrite dans le document FR 2 796 148

L'agencement du substrat de construction **10,** de la couche de passivation **12,** de la couche réfléchissante **14** et d'une membrane **16, 18, 20** constitue un élément sensible unitaire d'un agencement matriciel du détecteur, comme cela est connu en soi.

En fonctionnement, la couche réfléchissante **14** renvoie en direction de la membrane absorbante **16, 18, 20** un flux infrarouge ayant traversé celle-ci sans avoir été absorbé, augmentant de ce fait le pouvoir d'absorption global du détecteur par un phénomène de résonance.

Selon l'invention, la couche de passivation **12** comprend des motifs tridimensionnels étagés **30, 32,** de surfaces parallèles aux membranes **16, 18, 20,** formés sur la surface de la couche de passivation **12** orientée vers les membranes **16, 18, 20** et recouverts par la couche réfléchissante métallique **14.**

Ces motifs tridimensionnels étagés **30, 32** sont distribués régulièrement à une distance D1 et une distance D2 des membranes **16, 18, 20.** De manière préférentielle, les distances D1 et D2 sont sensiblement égales à 3 et 2 micromètres respectivement.

Par ailleurs, le rapport de surfaces entre les motifs séparés des membranes de la distance D1 et les motifs séparés des membranes **16, 18, 20** de la distance D2 est choisi sensiblement égal à 40%. Cette proportion représente un cas favorable dans cet exemple particulier de description, mais ne constitue en rien une proportion typique préférentielle.

Ainsi, on peut noter qu'une cavité définie par la membrane **16, 18, 20** d'un élément sensible unitaire et les motifs tridimensionnels **32** séparés de la distance D1 forme une lame quart d'onde pour la longueur d'onde 3 micromètres. La réponse de l'élément sensible est donc amplifiée pour une gamme de longueurs d'onde comprise entre sensiblement 8 et sensiblement 14 micromètres.

De manière analogue, une cavité définie par la membrane et les motifs tridimensionnels **30** séparés de la distance D2 forme une lame quart d'onde pour la longueur d'onde 2 micromètres. La réponse de l'élément sensible est donc amplifiée pour une gamme de longueurs d'onde comprise entre sensiblement 6 et sensiblement 12 micromètres.

Ainsi, à l'intérieur de chaque élément sensible unitaire du détecteur, la distance entre la membrane **16, 18, 20** de l'élément et la couche réfléchissante métallique **14** est variable. Cette variabilité interne à l'élément permet de moduler la contribution de chaque lame quart d'onde à la réponse globale de l'élément unitaire sensible.

La figure 4 illustre ce phénomène pour le détecteur ainsi décrit. Sur cette figure, la contribution des motifs **30** séparés des membranes **16, 18, 20** par la distance D1 de 2 micromètres est représentée par la courbe C1, et la contribution des motifs **32** séparés des membranes **16, 18, 20** par la distance D2 de 3 micromètres est représentée par la courbe C2. La réponse globale du détecteur est quant à elle représentée par la courbe C3.

Comme on peut le constater pour les infrarouges moyens, le choix des distances D1 et D2 ainsi que le rapport des surface a pour effet que le minimum de la courbe C1 correspond sensiblement au maximum de la courbe C2, et vice et versa. Il résulte donc de la combinaison des contributions des deux types de motifs tridimensionnels, que la réponse globale C3 du détecteur pour les infrarouges moyens présente une variabilité réduite qui rend la détection des infrarouges moyens plus facilement exploitable.

De plus, le niveau moyen de la réponse du détecteur entre les infrarouges moyens et les infrarouges thermiques, c'est-à-dire la réponse du détecteur dans la gamme de 5 micromètres à 8 micromètres, est augmenté. De fait, ce détecteur permet d'exploiter une gamme continue de longueurs d'ondes entre environs 3 micromètres et 14 micromètres, à la différence d'un détecteur selon l'état antérieur de la technique présentant la réponse selon la courbe A (figure 1).

On remarquera également, que pour obtenir une détection exploitable dans les infrarouges moyens, il n'est pas nécessaire de fabriquer des cavités submicrométriques. En effet, la distance la plus courte D1 est égale à environ 2 micromètres.

En outre, on notera également que le fait de rendre le détecteur exploitable dans les infrarouges moyens s'accompagne dans le premier mode de réalisation d'une perte minime du pouvoir de détection dans les infrarouges thermiques. En effet, la réponse globale dans la gamme de 8 micromètres à 14 micromètres est inférieure de moins de 5% à la réponse globale de l'état de la technique illustrée par la courbe A de la figure 1.

De préférence, un pas de répétition des motifs tridimensionnels est choisi de manière à éviter des phénomènes de diffraction, dommageables pour la qualité de la réponse du détecteur dans la gamme de longueurs d'onde d'intérêt. Pour le détecteur selon la premier mode de réalisation, ce pas de répétition est inférieur à 4 micromètres afin de ne pas dégrader la qualité de la réponse entre 3 à 14 micromètres.

De préférence, la formation des motifs est obtenue, lors de la fabrication du détecteur, au moyen d'une texturation de la couche de passivation **12** par gravure locale et partielle d'une surface libre de celle-ci (c'est-à-dire avant le dépôt de la couche réfléchissante **14),** à l'aide d'un masque lithographique correspondant aux motifs tridimensionnels **30, 32.**

On peut noter que la couche de passivation **12** peut être formée en réalité de plusieurs couches. Comme cela a été mentionné précédemment, dans le cas où la texturation est réalisée dans la couche de passivation, on s'assure que cette texturation ne dégrade pas le caractère passivant de la couche **12.** Avantageusement, une couche additionnelle de passivation est ajoutée, cette couche étant celle subissant la texturation, de sorte que le caractère passivant des couches sous-jacentes est conservé. Bien entendu, dans le cas où la ou les couches de passivation classiques peuvent subir la texturation sans dégradation de leur caractère passivant, la couche additionnelle peut être omise.

Bien qu'il ait été décrit une texturation de la surface de la couche de passivation **12,** on comprendra que d'autres texturations sont possibles. Par exemple, les motifs tridimensionnels sont formés dans le substrat de construction **10,** le dépôt successif des autres couches étant uniforme afin de laisser apparaître au final des motifs en regard des membranes **16, 18, 20.**

Il a été décrit un mode de réalisation particulier de détecteur bolométrique à membrane suspendue destiné à la détection d'une gamme large d'infrarouges grâce à une sélection particulière de motifs tridimensionnels étagés formés dans la surface d'un substrat réfléchissant.

La réponse globale du détecteur est façonnée en partie par la variabilité de la distance séparant la membrane d'un élément unitaire sensible et le substrat. D'autres caractéristiques permettent de régler la contribution de chaque type de motifs à la réponse globale du détecteur, notamment le pouvoir réfléchissant de chaque type de motifs.

En effet, moduler le pouvoir réfléchissant d'un type de motifs module sa contribution à la réponse globale du détecteur.

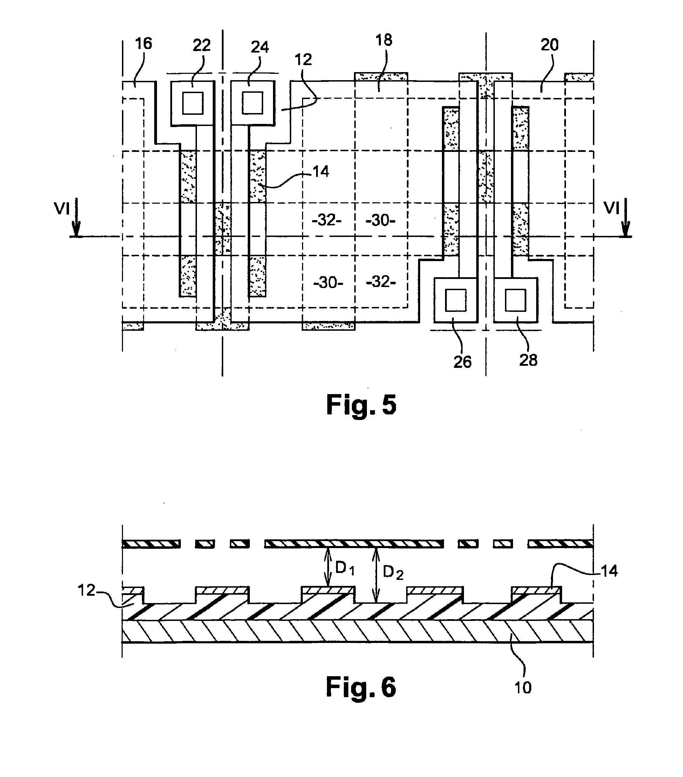

Par exemple, un second mode de réalisation, illustré aux figures 5 et 6, est analogue à celui décrit aux figures 2 et 3, à la différence que seuls les motifs **30,** séparés des membranes par la distance D2 la plus courte, sont recouverts de la couche réfléchissante **14.** Usuellement, la couche de passivation **12** présente un pouvoir de réflexion non nul, mais inférieur à celui de la couche **14.** De fait, la contribution des motifs **32** les plus éloignés est réduite. Ceci a pour effet d'une part d'offrir un moyen supplémentaire de moduler les pouvoirs de réflexion respectifs, et donc le spectre de sensibilité résultant du détecteur, mais aussi, très avantageusement, d'économiser un niveau lithographique lors de la fabrication de la structure. En effet, pour le ou les modes de réalisation où le réflecteur s'étend sur toute la surface réfléchissante, il faut mettre en oeuvre un niveau lithographique pour définir la texturation, et un autre niveau lithographique pour délimiter les contours du réflecteur (sinon toutes les structures seraient en cours circuit). Dans le cas avantageux évoqué, le niveau lithographique nécessaire à la définition du réflecteur est utilisé en même temps pour définir la texturation de la surface réfléchissante. Le processus est simplifié et donc plus économique.

De même, le rapport des surfaces entre les différents motifs permet de moduler la contribution de chaque type de motifs. Ainsi pour obtenir un détecteur bolométrique destiné à la détection des infrarouges moyens, le rapport de surfaces entre les motifs séparés des membranes de la distance D1 et les motifs séparés des membranes **16, 18, 20** de la distance D2 est compris entre environ 35% et environ 65% en fonction de type de réponse recherchée.

Par exemple, le second mode de réalisation diffère du premier mode de réalisation en ce que les motifs tridimensionnels sont agencés en damier régulier. Le rapport des surfaces des deux types de motifs est ainsi sensiblement égal à 50%. Ce chiffre est donné à titre exemplatif, et n'est pas préférentiel.

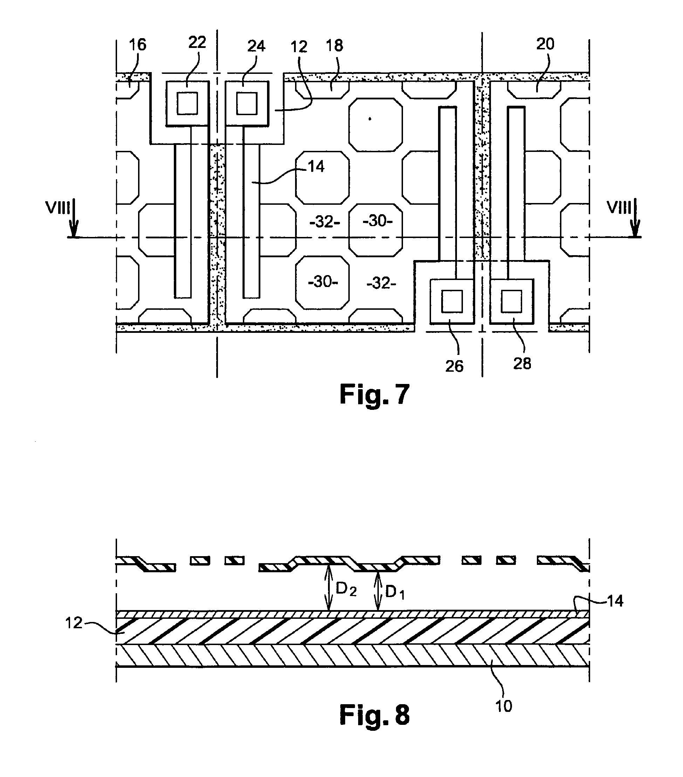

Bien qu'il ait été décrit des modes de réalisation dans lesquels la variabilité de distance est obtenue par la formation de motifs tridimensionnels dans le substrat, en variante, cette variabilité est obtenue par la formation de motifs tridimensionnels dans les membranes, comme cela est illustré aux figures 7 et 8.

Ce troisième mode de réalisation est analogue aux précédents à la différence que des motifs, de formes et dimensions identiques à celles du premier mode de réalisation décrit en relation avec les figures 2 et 3, sont formés dans les membranes.

Un avantage de former les motifs dans les membranes et non pas dans le substrat, est que la sensibilité du détecteur aux phénomènes de diffraction apparaissant sur des motifs tridimensionnels dans le substrat sont sensiblement éliminés. Un désavantage est une fabrication plus complexe. En effet, la formation de motifs dans le substrat est plus aisée.

En variante, les motifs tridimensionnels sont formés à la fois dans le substrat et les membranes, par exemple pour obtenir un compromis entre facilité de construction et atténuation des phénomènes de diffraction.

Bien qu'il ait été décrit des modes de réalisation dans lesquels, des motifs sensiblement plans forment des cavités de surfaces parallèles, d'autres types de motifs peuvent être utilisés. En variante, la surface du substrat et/ou la membrane présente un profil ondulé, par exemple du type sinusoïdal.

On comprendra bien évidemment que la variabilité de la distance entre les membranes et le substrat réfléchissant est dictée par le type d'application visée ainsi que les caractéristiques intrinsèques du détecteur.

De manière particulière, la présente invention trouve application dans le domaine des capteurs d'image à détection bolométrique, quelle que soit la bande de fréquences de détection ou du type de matériau bolométrique utilisé pour fabriquer les bolomètres d'imagerie et de référence, comme par exemple du silicium amorphe (a-Si), de l'oxyde de vanadium (VOx), de l'oxyde métallique (Ti).

## Revendications

1. Détecteur de rayonnement électromagnétique comportant un substrat recouvert d'une couche métallique réfléchissante (10, 12, 14) et au moins un élément de détection comprenant une membrane bolométrique (16, 18, 20) sensible audit rayonnement et suspendue au-dessus du substrat (10, 12, 14), la membrane comprenant un matériau bolométrique et une couche métallique de résistance de couche comprise entre environ 300 ohms par carré et environ 400 ohms par carrée, *caractérisé* :
■ en ce que le substrat (10, 12, 14) et/ou la membrane (16, 18, 20) présentent des motifs tridimensionnels (30, 32) selon une distribution spatiale prédéterminée, la membrane et le substrat étant sensiblement parallèles par morceaux, et la distance séparant la membrane et le substrat étant distribuée entre une première et une seconde valeurs (D1, D2) prédéterminées ;
■ en ce que les première et seconde valeurs de distance (D1, D2) définissent respectivement un premier et une second types de cavités résonantes quart d'onde dans une première gamme de longueurs d'onde, chaque type de cavité définissant un pic principal de détection dans la première gamme de longueurs d'onde et un pic secondaire de détection dans une seconde gamme de longueurs d'onde différente de la première gamme de longueurs d'onde; et
■ en ce que les distances (D1, D2) sont choisies de manière à ce que le minimum, localisé entre le pic principal et le pic secondaire de la première distance, corresponde au maximum du pic secondaire de la seconde distance.

2. Détecteur de rayonnement électromagnétique selon la revendication 1, ***caractérisé* en ce que** les aires de surfaces correspondant à différentes valeurs de distance entre la membrane et le substrat sont identiques ou différentes.

3. Détecteur de rayonnement électromagnétique selon l'une quelconque des revendications précédentes, ***caractérisé* en ce que** la membrane comporte un matériau bolométrique sensible à une variation de température résultant d'une exposition à un rayonnement infrarouge.

4. Détecteur de rayonnement électromagnétique selon la revendication 3, ***caractérisé* en ce que** la membrane est sensible à des longueurs d'onde comprises entre environ 3 micromètres et environ 14 micromètres.

5. Détecteur de rayonnement électromagnétique selon l'une des revendications 3 et 4, ***caractérisé* en ce que** les première et seconde valeurs de distance sont sensiblement égales à 3 et 2 micromètres respectivement.

6. Détecteur de rayonnement électromagnétique selon la revendication 5, ***caractérisé* en ce que** le rapport entre la surface de la membrane séparée du substrat par la première distance et la surface de la membrane séparée du substrat par la seconde distance est compris entre environ 35 et environ 65 pourcents.

7. Détecteur de rayonnement électromagnétique selon la revendication 1 et l'une quelconque des revendications 3 à 6, ***caractérisé* en ce que** les motifs tridimensionnels (30, 32) sont répétitifs, et **en ce qu'**un pas de répétition de ceux-ci est inférieur ou égal à 4 micromètres.

8. Procédé de fabrication d'un détecteur de rayonnement électromagnétique, du type comportant une étape de formation d'un substrat recouvert d'une couche métallique réfléchissante (10, 12, 14) et d'une membrane (16, 18, 20) d'au moins un élément de détection sensible à un rayonnement, et une étape de suspension de la membrane au-dessus du substrat, la membrane comprenant un matériau bolométrique et une couche métallique de résistance de couche comprise entre environ 300 ohms par carré et environ 400 ohms par carrée, ***caractérisé* en ce que** le substrat (10, 12, 14) et/ou la membrane (16, 18, 20) présentent des motifs tridimensionnels (30, 32) selon une distribution spatiale prédéterminée, la membrane et le substrat étant sensiblement parallèles par morceaux, et la distance séparant la membrane et le substrat étant distribuée entre une première et une seconde valeurs (D1, D2) prédéterminées ;
■ **en ce que** les première et seconde valeurs de distance (D1, D2) définissent respectivement un premier et une second types de cavités résonantes quart d'onde dans une première gamme de longueurs d'onde, chaque type de cavité définissant un pic principal de détection dans la première gamme de longueurs d'onde et un pic secondaire de détection dans une seconde gamme de longueurs d'onde différente de la première gamme de longueurs d'onde; et
■ **en ce que** les distances (D1, D2) sont choisies de manière à ce que le minimum, localisé entre le pic principal et le pic secondaire de la première distance corresponde au maximum du pic secondaire de la seconde distance.

## Claims

1. A detector of electromagnetic radiation comprising a substrate covered by a metal reflecting layer (10, 12, 14) and at least one detection element comprising a bolometric membrane (16, 18, 20) sensitive to said radiation and suspended above the substrate (10, 12, 14), the membrane comprising a bolometric material and a metal layer of which the layer resistance is between about 300 Ohms per square and about 400 Ohms per square, ***characterized* :**
• **in that** the substrate (10, 12, 14) and/or the membrane (16, 18, 20) have 3D motifs (30, 32) according to a predefined spatial distribution, the membrane and the substrate being substantially parallel in portions, and the distance between the membrane and the substrate being distributed between a first and a second predefined values (D1, D2),
• **in that** the first and second distance values (D1, D2) respectively define a first and a second type of quarter wave resonance cavity in a first range of wavelengths, each type of cavity defining a principal detection peak in the first range of wavelengths and a secondary detection peak in a second range of wavelengths different from the first range of wavelengths, and
• **in that** the distance values (D1, D2) are selected so that the minimum localized between the principal peak and the secondary peak of the first distance value corresponds to the maximum of the secondary peak of the second distance value.

2. The electromagnetic radiation detector as claimed in claim 1, ***characterized* in that** the surface areas corresponding to various distance values between the membrane and the substrate are identical or different.

3. The electromagnetic radiation detector as claimed in any of the preceding claims, ***characterized* in that** the membrane comprises a bolometric material sensitive to a temperature variation resulting from exposure to infrared radiation.

4. The electromagnetic radiation detector as claimed in claim 3, ***characterized* in that** the membrane is sensitive to wavelengths between about 3 microns and about 14 microns.

5. The electromagnetic radiation detector as claimed in either of claims 3 and 4, ***characterized* in that** the first and second distance values are substantially equal to 3 and 2 microns respectively.

6. The electromagnetic radiation detector as claimed in claim 5, ***characterized* in that** the ratio of the area of the membrane separated from the substrate by the first distance to the area of the membrane separated from the substrate by the second distance is between about 35 and about 65 percent.

7. The electromagnetic radiation detector as claimed in claim 1 and any one of claims 3 to 6, ***characterized* in that** the 3D motifs (30, 32) are repetitive, and **in that** their repetition step is lower than or equal to 4 microns.

8. A method for manufacturing an electromagnetic radiation detector, of the type comprising a step of formation of a substrate covered by a metal reflecting layer (10, 12, 14) and of a membrane (16, 18, 20), of at least one detection element sensitive to a radiation, and a step of suspension of the membrane above the substrate, the membrane comprising a bolometric material and a metal layer of which the layer resistance is between about 300 Ohms per square and about 400 Ohms per square, ***characterized* in that** the substrate (10, 12, 14) and/or the membrane (16, 18, 20) have 3D motifs (30, 32) according to a predefined spatial distribution, the membrane and the substrate being substantially parallel in portions, and the distance between the membrane and the substrate being distributed between a first and a second predefined values (D1, D2),
• **in that** the first and second distance values (D1, D2) respectively define a first and a second type of quarter wave resonance cavity in a first range of wavelengths, each type of cavity defining a principal detection peak in the first range of wavelengths and a secondary detection peak in a second range of wavelengths different from the first range of wavelengths, and
• **in that** the distance values (D1, D2) are selected so that the minimum localized between the principal peak and the secondary peak of the first distance value corresponds to the maximum of the secondary peak of the second distance value.

## Patentansprüche

1. Detektor für elektromagnetische Strahlung, ein Substrat, das mit einer reflektierenden Metallschicht (10, 12, 14) bedeckt ist, und mindestens ein Erfassungselement umfassend, das eine bolometrische Membran (16, 18, 20) umfasst, die empfindlich auf die Strahlung anspricht und über dem Substrat (10, 12, 14) aufgehängt ist, wobei die Membran ein bolometrisches Material und eine Metallschicht mit einem Schichtwiderstand zwischen ca. 300 Ω/□ und ca. 400 Ω/□ umfasst, **dadurch gekennzeichnet, dass**:
■ das Substrat (10, 12, 14) und/oder die Membran (16, 18, 20) dreidimensionale Muster (30, 32) in einer vorbestimmten räumlichen Verteilung aufweist/aufweisen, wobei die Membran und das Substrat stückweise im Wesentlichen parallel sind, und der Abstand, der die Membran und das Substrat trennt, zwischen einem ersten und zweiten vorbestimmten Wert (D1, D2) verteilt ist;
■ der erste und zweite Abstandswert (D1, D2) jeweils einen ersten und einen zweiten Typ von Viertelwellenresonanzhohlräumen in einem ersten Bereich von Wellenlängen definieren, wobei jeder Hohlraumtyp einen Erfassungshauptscheitelpunkt im ersten Bereich von Wellenlängen und einen sekundären Erfassungsscheitelpunkt in einem zweiten Bereich von Wellenlängen definiert, der sich vom ersten Bereich von Wellenlängen unterscheidet; und
■ die Abstände (D1, D2) so gewählt sind, dass das zwischen dem Hauptscheitelpunkt und dem sekundären Scheitelpunkt des ersten Abstands liegende Minimum dem Maximum des sekundären Scheitelpunkts des zweiten Abstands entspricht.

2. Detektor für elektromagnetische Strahlung nach Anspruch 1, **dadurch gekennzeichnet, dass** die Flächeninhalte, die verschiedenen Abstandswerten zwischen der Membran und dem Substrat entsprechen, gleich oder verschieden sind.

3. Detektor für elektromagnetische Strahlung nach einem der vorhergehenden Ansprüche, **dadurch gekennzeichnet, dass** die Membran ein bolometrisches Material umfasst, das empfindlich hinsichtlich einer Temperaturänderung ist, die sich aus einer Bestrahlung mit Infrarotstrahlung ergibt.

4. Detektor für elektromagnetische Strahlung nach Anspruch 3, **dadurch gekennzeichnet, dass** die Membran empfindlich hinsichtlich Wellenlängen ist, die zwischen ca. 3 Mikrometer und ca. 14 Mikrometer betragen.

5. Detektor für elektromagnetische Strahlung nach einem der Ansprüche 3 und 4, **dadurch gekennzeichnet, dass** der erste und zweite Abstandswert im Wesentlichen gleich 3 bzw. 2 Mikrometer sind.

6. Detektor für elektromagnetische Strahlung nach Anspruch 5, **dadurch gekennzeichnet, dass** das Verhältnis zwischen der Oberfläche der Membran, die durch den ersten Abstand vom Substrat getrennt ist, und der Oberfläche der Membran, die durch den zweiten Abstand vom Substrat getrennt ist, zwischen ca. 35 und ca. 65 Prozent beträgt.

7. Detektor für elektromagnetische Strahlung nach Anspruch 1 und einem der Ansprüche 3 bis 6, **dadurch gekennzeichnet, dass** die dreidimensionalen Muster (30, 32) sich wiederholen, und dass ein Wiederholungsschritt von diesen kleiner als oder gleich 4 Mikrometer ist.

8. Verfahren zur Herstellung eines Detektors für elektromagnetische Strahlung, der Art, die einen Schritt zum Ausbilden eines Substrats, das mit einer reflektierenden Metallschicht (10, 12, 14) bedeckt ist, und einer Membran (16, 18, 20) mindestens eines empfindlich auf eine Strahlung ansprechenden Erfassungselements, und einen Schritt des Aufhängens der Membran über dem Substrat umfasst, wobei die Membran ein bolometrisches Material und eine Metallschicht mit einem Schichtwiderstand zwischen ca. 300 Ω/□ und ca. 400 Ω/□ umfasst, **dadurch gekennzeichnet, dass** das Substrat (10, 12, 14) und/oder die Membran (16, 18, 20) dreidimensionale Muster (30, 32) in einer vorbestimmten räumlichen Verteilung aufweist/aufweisen, wobei die Membran und das Substrat stückweise im Wesentlichen parallel sind, und der Abstand, der die Membran und das Substrat trennt, zwischen einem ersten und zweiten vorbestimmten Wert (D1, D2) verteilt ist;
■ der erste und zweite Abstandswert (D1, D2) jeweils einen ersten und einen zweiten Typ von Viertelwellenresonanzhohlräumen in einem ersten Bereich von Wellenlängen definieren, wobei jeder Hohlraumtyp einen Erfassungshauptscheitelpunkt im ersten Bereich von Wellenlängen und einen sekundären Erfassungsscheitelpunkt in einem zweiten Bereich von Wellenlängen definiert, der sich vom ersten Bereich von Wellenlängen unterscheidet; und
■ die Abstände (D1, D2) so gewählt sind, dass das zwischen dem Hauptscheitelpunkt und dem sekundären Scheitelpunkt des ersten Abstands liegende Minimum dem Maximum des sekundären Scheitelpunkts des zweiten Abstands entspricht.
